(19) Europäisches Patentamt
European Patent Office
Office européen des brevets

(11) EP 4 780 176 A1

(12) EUROPEAN PATENT APPLICATION

(43) Date of publication:
**22.07.2026 Bulletin 2026/30**

(21) Application number: **26150556.4**

(22) Date of filing: **07.01.2026**

(51) International Patent Classification (IPC):
***H10K 30/82*** *(2023.01)* ***H10K 85/50*** *(2023.01)*
***H10K 71/60*** *(2023.01)*

(52) Cooperative Patent Classification (CPC):
**H10K 30/82;** H10K 71/60; H10K 85/50;
H10K 2102/351

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **17.01.2025 JP 2025006711**
**23.12.2025 JP 2025279230**

(71) Applicant: **Enecoat Technologies Co., Ltd.**
**Kyoto 613-0031 (JP)**

(72) Inventors:
- **CHANTANA, Jakapan**
  **Kyoto, 6130031 (JP)**
- **KANEKO, Ryuji**
  **Kyoto, 6130031 (JP)**
- **NISHITANI, Junichi**
  **Kyoto, 6130031 (JP)**

(74) Representative: **Becker, Eberhard**
**Becker Kurig & Partner**
**Patentanwälte mbB**
**Bavariastraße 7**
**80336 München (DE)**

# (54) TRANSPARENT CONDUCTIVE LAMINATE AND PHOTOELECTRIC CONVERSION ELEMENT

(57) Provided is a photoelectric conversion element (10) capable of achieving high output by using a transparent conductive laminate (1) with excellent light transmittance or the like as an electrode. To achieve this, the transparent conductive laminate (1) of the disclosure is a laminate including two or more transparent conductive films (2a, 2b) formed on a light-transmitting support (11), and the doping concentration (D1) of a first transparent conductive film (2a) on the side close to the support and the doping concentration (D2) of a second transparent conductive film (2b) on the side far from the support satisfy the following formula.

$$D1>D2...(1)$$

According to the transparent conductive laminate of the disclosure, it is possible to provide a photoelectric conversion element capable of achieving high output.

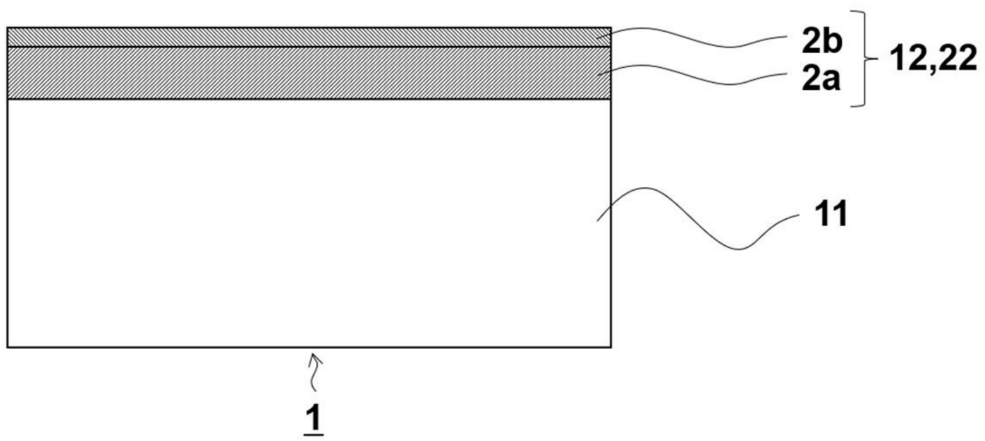


FIG. 1



Processed by Luminess, 75001 PARIS (FR)

## Description

### Technical Field

The disclosure relates to a transparent conductive laminate and a photoelectric conversion element.

### Background Art

In recent years, solar power generation has attracted attention as a clean energy source, and the development of solar cells has been progressing. As one of them, solar cells using perovskite materials in the light absorption layer are rapidly drawing attention as next-generation solar cells that can be manufactured at low cost. For example, Non-Patent Document 1 reports a solution-type solar cell using a perovskite material in the light absorption layer, and Non-Patent Document 2 reports that solid-type perovskite solar cells exhibit high efficiency.

Known basic structures of perovskite solar cells include: a normal structure in which an electron transport layer, a light absorption layer (perovskite layer), a hole transport layer (also called a hole-transporting layer), and a back electrode are laminated in this order on an electrode; and an inverted structure in which a hole transport layer, a light absorption layer, an electron transport layer, and a back electrode are laminated in this order on an electrode, and among these, a transparent conductive film is used for the electrode.

### Related Art Documents

### Non-Patent Documents

[Non-Patent Document 1] Journal of the American Chemical Society, 2009, 131, 6050-6051.
[Non-Patent Document 2] Science, 2012, 388, 643-647.

### SUMMARY

### Problem to be Solved by the Invention

Because solar cells need to capture a large amount of light in the light absorption layer, at least one of the electrodes uses a transparent conductive film such as tin-doped indium oxide, and improving the light transmission performance of this transparent conductive film improves the performance as a solar cell.

Therefore, the disclosure provides a photoelectric conversion element capable of achieving high output by using a transparent conductive laminate with excellent light transmittance or the like as an electrode.

### Means for Solving the Problem

To achieve this, a transparent conductive laminate of the disclosure is a laminate including transparent conductive films that include two or more transparent films formed on a light-transmitting support, and is characterized in that a doping concentration (D1) of a first transparent film on a side close to the support and a doping concentration (D2) of a second transparent film on a side far from the support satisfy the following formula.

$$D1>D2...(1)$$

The transparent conductive laminate of the disclosure is characterized in that the first transparent film and the second transparent film have a metal oxide of indium (In) as a main component, and a doping component is tin (Sn) or tungsten (W).

A transparent conductive laminate of the disclosure is a laminate including transparent conductive films that include two or more transparent films formed on a light-transmitting support, and is characterized in that a refractive index (N1) of a first transparent film on a side close to the support and a refractive index (N2) of a second transparent film on a side far from the support satisfy the following formula.

$$N1<N2...(2)$$

The transparent conductive laminate of the disclosure is characterized in that a film thickness (T1) of the first transparent conductive film and a film thickness (T2) of the second transparent conductive film satisfy the following formula.

$$T1>T2...(3)$$

The transparent conductive laminate of the disclosure is characterized in that the first transparent film is an optical adjustment film having a metal oxide as a main component, and the second transparent film is a transparent conductive film having a metal oxide of indium (In) as a main component.

A photoelectric conversion element of the disclosure is characterized by using a transparent conductive film of the transparent conductive laminate as an electrode for photoelectric conversion element.

A photoelectric conversion element of the disclosure includes the transparent conductive laminate, a hole transport layer, a photoelectric conversion layer, an electron transport layer, and a second electrode in this order, and is characterized in that a first electrode is a transparent conductive film of the laminate, and the hole transport layer is formed on the second transparent film of the transparent conductive film.

The photoelectric conversion element of the disclosure is characterized in that the hole transport layer includes a compound represented by the following general formula (4).

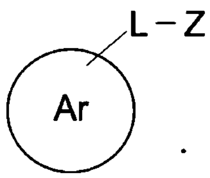

. . . (4)

In the chemical formula (4), Ar is a structure including an aromatic ring, and may or may not include a hetero atom among atoms constituting the aromatic ring, Ar may or may not have a substituent other than -L-Z, -L-Z may be one or more, and in the case of more than one, each L and each Z may be the same as or different from each other, each L is an atomic group that bonds Ar and Z, or is a covalent bond, and each Z is a group capable of forming a chemical bond or hydrogen bond with a metal oxide.

The photoelectric conversion element of the disclosure is characterized in that the hole transport layer includes the compound represented by the general formula (4) and a p-type metal oxide.

The photoelectric conversion element of the disclosure is characterized in that the p-type metal oxide is selected from any of nickel oxide, copper oxide, aluminum copper oxide, and aluminum nickel oxide.

The photoelectric conversion element of the disclosure is characterized in that the photoelectric conversion layer is a perovskite layer including a perovskite structure.

The photoelectric conversion element of the disclosure includes insulating nanoparticles between the hole transport layer and the perovskite layer.

In the photoelectric conversion element of the disclosure, a median particle diameter of the insulating nanoparticles is in a range of 1 nm to 100 nm.

Effects of the Invention

According to the disclosure, it is possible to provide a transparent conductive laminate with excellent light transmittance or the like, or a photoelectric conversion element capable of achieving high output.

BRIEF DESCRIPTION OF THE DRAWINGS

FIG. 1 is a cross-sectional view showing an example of the transparent conductive laminate of the disclosure.

FIG. 2 is a cross-sectional view showing an example of a normal structure of the photoelectric conversion element of the disclosure.

FIG. 3 is a cross-sectional view showing an example of an inverted structure of the photoelectric conversion element of the disclosure.

FIG. 4 is a measurement diagram of a spectroscopic ellipsometer for an ITO single film.

FIG. 5 is a measurement diagram of a spectroscopic ellipsometer for an indium oxide single film.

FIG. 6 is a measurement diagram of a spectroscopic ellipsometer for an IWO single film.

FIG. 7 is a graph showing the relationship between the average transmittance of the transparent conductive laminate of the disclosure and the average refractive index of the optical adjustment film.

## DESCRIPTION OF THE EMBODIMENTS

The disclosure will be described in further detail with examples. However, the disclosure is not limited by the following description. Further, in the disclosure, unless otherwise specified, "mass%" and "weight%" may be read interchangeably with each other, and "parts by mass" and "parts by weight" may be read interchangeably with each other. In the disclosure, "on" or "on a surface" may refer to a state of being in direct contact on or on a surface, or may refer to a state via other components or the like.

Hereinafter, the disclosure will be described specifically with reference to the drawings. However, the disclosure is not limited to the following examples. In addition, each drawing is a schematic diagram shown to facilitate illustration, and the dimensional ratios and shapes may differ from the cross-sectional structures of the actual laminate and element.

FIG. 1 is a cross-sectional view showing an example of a transparent conductive laminate 1. The laminate 1 includes a light-transmitting support 11 and transparent conductive films 2a and 2b, as transparent films, formed on a surface of the support 11. The support 11 is composed of a material having light-transmitting property. The material is not particularly limited, and for example, a substrate used for general solar cells may be appropriately used. Examples of the substrate include glass, plastic plates including plastic films, plastic films, inorganic crystals and the like. The thickness of the substrate is not particularly limited. In the case of the substrate being glass, for example, the thickness of the substrate is preferably 0.3 mm to 1.1 mm. In the case of a plastic film, for example, the thickness of the substrate is preferably 25 μm to 125 μm. Further, a substrate on which at least one type of a metal film, a semiconductor film, a conductive film, and an insulating film is formed on part of or the entirety of these substrate surfaces may also be suitably used as the support 11. It is noted that the "light-transmitting property" required for the support 11 is optimally achieved by a material having light transmission characteristics with a light transmittance in the visible light region of 50% or more, and preferably 80% or more.

It is noted that the transparent conductive laminate 1 of the disclosure may have three or more transparent films or transparent conductive films laminated, as long as the features of the laminate 1 are not impaired.

The transparent conductive films, serving as transparent films, are laminated in two layers, with a first transparent film (first transparent conductive film) 2a on the side close to the support 11 and a second transparent film (second transparent conductive film 2b) on the side far from the support 11. The transparent conductive film 2a and the transparent conductive film 2b have a metal oxide as a main component and include a doping component to enhance conductive performance while maintaining light transmittance. It is noted that in the case of light transmittance and conductive performance not being impaired, the transparent conductive film 2b may not include a doping component.

The first transparent conductive film 2a may be formed directly on the surface of the support 11. The first transparent conductive film 2a and the second transparent conductive film 2b need to have transparency as described above. It is noted that the "transparency" required for the transparent conductive film is optimally achieved by having light transmission characteristics with a visible light transmittance of 50% or more, and preferably 80% or more.

The material of the transparent conductive films, serving as transparent films, is not particularly limited, but it is preferable from manufacturing and economic perspectives to use tin-doped indium oxide (ITO), tungsten-doped indium oxide (IWO), and indium oxide. In addition, combinations with indium-doped zinc oxide (IZO), boron-doped zinc oxide (BZO), aluminum-doped zinc oxide (AZO), fluorine-doped tin dioxide (FTO), antimony-doped tin oxide (ATO), niobium-doped tin oxide, niobium-doped titanium oxide, and the like, or compositions of these metal oxides may be used.

The doping concentration (D1) of the first transparent conductive film 2a and the doping concentration (D2) of the second transparent conductive film 2b are laminated to satisfy the relationship of the following formula (1).

$$D1>D2...(1)$$

Here, the doping concentration of each transparent conductive film means the ratio of the mass of the doping component to the mass of the entire transparent conductive film. In the case where there are variations in doping concentration in each transparent conductive film, it is possible to convert the doping concentration by the mass ratio of the entire film region having the function of transmitting light.

The general concentration ranges of D1 and D2 are 0.1% to 30% (D1) and 0% to 15% (D2), respectively. Further, the preferable concentration ranges are 0.5% to 25% (D1) and 0% to 13% (D2), respectively. Furthermore, the optimal concentration ranges are 1% to 20% (D1) and 0% to 10% (D2), respectively.

The transparent conductive laminate 1 of the disclosure is laminated such that the doping concentration of the transparent conductive film decreases as the distance from the support side increases, thereby making it possible to achieve a conductive film with high transparency.

The transparent conductive films in the disclosure include the first transparent conductive film 2a and the second transparent conductive film 2b having a metal oxide of indium (In) as a main component, and the doping component includes tin (Sn) or tungsten (W).

Since the first transparent conductive film 2a and the second transparent conductive film 2b have a metal oxide of indium (In) as a main component and the doping component includes tin (Sn) or tungsten (W), it is easy to manufacture the transparent conductive films, and it becomes possible to stabilize the quality of durability and transparency.

It is noted that within a range that does not affect the durability and transparency of the transparent conductive films, the first transparent conductive film 2a and the second transparent conductive film 2b may be combined with a transparent conductive film having a metal oxide of zinc (Zn), tin (Sn), or titanium (Ti) as a main component and having indium (In), boron (B), fluorine (F), niobium (Nb), or antimony (Sb) as a doping component.

The refractive index (N1) of the first transparent conductive film 2a and the refractive index (N2) of the second transparent conductive film 2b are laminated to satisfy the relationship of the following formula (2).

$$N1<N2...(2)$$

Here, the refractive index of each transparent conductive film is defined for light with a wavelength of 589.3 nm (sodium D line).

The general refractive indices of N1 and N2 are 1.0 to 1.4 (N1) and 1.41 to 3.0 (N2), respectively. Further, the preferable refractive indices are 1.05 to 1.4 (N1) and 1.41 to 2.5 (N2), respectively. Furthermore, the optimal refractive indices are 1.1 to 1.4 (N1) and 1.41 to 2.0 (N2), respectively.

The transparent conductive laminate 1 of the disclosure is laminated such that the refractive index decreases as the distance from the support 11 side increases. Lamination that makes the refractive index decrease as the distance from the support side increases suppresses reflection due to light interference and makes it possible to form a conductive film with high transparency.

The film thickness (T1) of the first transparent conductive film 2a and the film thickness (T2) of the second transparent conductive film 2b are laminated to satisfy the relationship of the following formula (3).

$$T1>T2...(3)$$

The transparent conductive films laminated in two or more layers in the disclosure are preferably laminated such that the film thickness decreases as the distance from the support 11 side increases.

The general film thickness ranges of T1 and T2 are 5 nm to 400 nm (T1) and 0.1 nm to 150 nm (T2), respectively. Further, the preferable film thickness ranges are 10 nm to 300 nm (T1) and 1.0 nm to 100 nm (T2), respectively. Furthermore, the optimal film thickness ranges are 20 nm to 250 nm (T1) and 5 nm to 80 nm (T2), respectively.

In addition, the ratio T2/(T1+T2) of the total film thickness (T1+T2) and the film thickness (T2) preferably satisfies the relationship of the following formula (4), preferably formula (5), and optimally formula (6).

$$1.0\% \leqq T2/(T1+T2) \leqq 45\%...(4)$$

$$5.0\% \leqq T2/(T1+T2) \leqq 25\%...(5)$$

$$10\% \leqq T2/(T1+T2) \leqq 20\%...(6)$$

The transparent conductive laminate 1 of the disclosure is laminated such that the film thickness of the transparent conductive film decreases as the distance from the support 11 side increases. Since the transparent conductive film on the support side has a large film thickness, it is possible to form a conductive film with high transparency without impairing the electrical conductive performance and durability performance of the transparent conductive film.

Hereinafter, a photoelectric conversion element using the transparent conductive film 2a and the transparent conductive film 2b of the transparent conductive laminate 1 of the disclosure as electrodes for photoelectric conversion

element will be described.

FIG. 2 is a cross-sectional view showing an example of a normal structure of the photoelectric conversion element of the disclosure, and FIG. 3 is a cross-sectional view showing an example of an inverted structure of the same photoelectric conversion element

The support 11 of the transparent conductive laminate 1 is used for supports 11 and 21. First electrodes 12 and 22 corresponding to the first transparent conductive film 2a and the second transparent conductive film 2b are respectively formed on the surfaces of the supports 11 and 21. The first electrodes 12 and 22 are layers that, for example, support an electron transport layer 13 and a hole transport layer 25, and have a function of extracting electrons or holes from photoelectric conversion layers 14 and 24. Additionally, the first electrode 12 is a layer that functions as an anode (negative electrode), and the first electrode 22 is a layer that functions as a cathode (positive electrode).

The first electrodes 12 and 22 in the disclosure have transparency. The transparency in the disclosure particularly means that visible light has no interaction with the first electrodes, and absorption and scattering of visible light are less likely to occur.

The first electrodes 12 and 22 may be respectively formed directly on the supports 11 and 21. The first electrodes 12 and 22 need to have transparency as described above, and although not particularly limited, tin-doped indium oxide (ITO), tungsten-doped indium oxide (IWO), and indium oxide are preferable. In addition, metal oxides such as indium-doped zinc oxide (IZO), boron-doped zinc oxide (BZO), aluminum-doped zinc oxide (AZO), fluorine-doped tin dioxide (FTO), antimony-doped tin oxide (ATO), niobium-doped tin oxide, and niobium-doped titanium oxide may be used.

The disclosure uses a first electrode laminated in two or more layers to enhance transparency. In the case of incident light from the support side, lamination that makes the doping concentration decrease from the support side makes it possible to form a conductive film with high transparency. Additionally, the second transparent conductive film 2b close to the photoelectric conversion layers 14 and 24 has a reduced concentration of doped carriers and impurities formed by the doping component, and recombination with electrons or holes moving from the photoelectric conversion layers 14 and 24 is suppressed, so it is considered that photoelectric conversion efficiency is also improved.

The first electrode laminated in two or more layers in the disclosure is preferably laminated such that the refractive index decreases as the distance from the support side increases, in the case of incident light from the support side. Furthermore, preferably the film thickness of the transparent conductive film decreases as the distance from the supports 11 and 21 side increases.

The thicknesses of the first electrodes 12 and 22 are not particularly limited, but for example, are preferably adjusted such that the sheet resistance becomes 5 Ω/□ to 15 Ω/□ (per unit area). The formation method of the first electrodes 12 and 22 is not particularly limited, but for example, the first electrodes 12 and 22 may be obtained by known film formation methods according to the material to be formed. The method for forming the first electrodes 12 and 22 on the supports 11 and 21 is not particularly limited, but known methods may be used, and for example, vacuum film formation such as vacuum deposition or sputtering is preferable. Further, the first electrodes 12 and 22 may be, for example, patterned. The patterning method is not particularly limited, and examples include methods such as laser or immersion in etching solution, and methods of patterning using a mask during vacuum film formation. Any method may be used in the disclosure. Additionally, the first electrodes 12 and 22 may be used in combination with metal wiring or the like, for example, for the purpose of reducing electrical resistance value. The material of the metal wiring (metal lead wire) is not particularly limited, and examples include aluminum, copper, silver, gold, platinum, nickel, and the like. The metal lead wire may be used in combination by, for example, forming the metal lead wire on a first substrate by deposition, sputtering, and pressure bonding, and providing an ITO or FTO layer thereon, or by providing the metal lead wire on ITO or FTO.

[Electron Transport Layer 13, 23]

The materials used for the electron transport layers 13 and 23 are not particularly limited and may be appropriately selected according to the purpose. For example, semiconductor materials are preferable. The semiconductor materials are not particularly limited and known semiconductor materials may be used, and examples include elemental semiconductors, compound semiconductors, organic n-type semiconductors, and the like.

The elemental semiconductors are not particularly limited, and examples include silicon, germanium, and the like. The compound semiconductors are not particularly limited, and examples include metal chalcogenides, specifically, oxides of titanium, tin, zinc, iron, tungsten, zirconium, hafnium, strontium, indium, cerium, yttrium, lanthanum, vanadium, niobium, tantalum, and the like; sulfides of cadmium, zinc, lead, silver, antimony, bismuth, and the like; selenides of cadmium, lead, and the like; tellurides of cadmium, and the like. Other compound semiconductors include phosphides of zinc, gallium, indium, cadmium, and the like, gallium arsenide, copper-indium-selenide, copper-indium-sulfide, and the like.

The organic n-type semiconductors are not particularly limited, and examples include perylene tetracarboxylic anhydride, perylene tetracarboxydiimide compounds, naphthalene diimide-bithiophene copolymers, benzobisimidazobenzophenanthroline polymers, fullerene compounds such as $C_{60}$, $C_{70}$, PCBM ([6,6]-phenyl-$C_{61}$-butyric acid methyl

ester), carbonyl bridge-bithiazole compounds, $ALq_3$ (tris(8-quinolinolato)aluminum), triphenylene bipyridyl compounds, silole compounds, oxadiazole compounds, and the like.

Among the aforementioned materials used for the electron transport layers 13 and 23, organic n-type semiconductors are particularly preferable.

The materials used for forming the electron transport layers 13 and 23 may be used alone, for example, or two or more types may be used in combination. In the case where the materials used for forming the electron transport layers 13 and 23 are semiconductor materials, the crystal form of the semiconductor materials is not particularly limited and may be appropriately selected according to the purpose, and may be single crystal or polycrystal, for example, and may be amorphous.

The film thickness of the electron transport layers 13 and 23 is not particularly limited and may be appropriately selected according to the purpose, but for example, 5 nm to 1000 nm is preferable, and 10 nm to 700 nm is more preferable.

The formation method of the electron transport layers 13 and 23 is not particularly limited and may be appropriately selected according to the purpose. Examples of the formation method include methods for forming thin films in vacuum (vacuum film formation methods) and wet film formation methods. Examples of the vacuum film formation methods include sputtering method, pulsed laser deposition method (PLD method), ion beam sputtering method, ion assist method, ion plating method, vacuum evaporation method, atomic layer deposition method (ALD method), chemical vapor deposition method (CVD method), and the like. Examples of the wet film formation methods include methods of applying a solvent in which electron transport materials are dissolved, and in the case where the materials used for forming the electron transport layers 13 and 23 are oxide semiconductors, sol-gel method, and the like. The sol-gel method is a method of producing a gel from a solution through chemical reactions such as hydrolysis and polymerization/condensation, and then promoting densification by heat treatment. In the case of using the sol-gel method, the application method of the sol solution is not particularly limited and may be appropriately selected according to the purpose, and examples include dip method, spray method, wire bar method, spin coating method, roller coating method, blade coating method, and gravure coating method. Further, wet printing methods include, for example, relief printing, offset printing, gravure printing, intaglio printing, rubber printing, screen printing, and the like. The temperature during heat treatment after applying the sol solution is preferably 80°C or higher, for example, and more preferably 100°C or higher.

In the case of the inverted structure shown in FIG. 3, an electron injection layer (hole blocking layer) may be formed between the electron transport layer 23 and the second electrode 26 after forming the electron transport layer 23. Examples of materials used for the electron injection layer include BCP (bathocuproine) and metal oxides such as tin oxide, and cesium or the like may be doped. The film thickness of the electron injection layer is preferably 1 nm to 100 nm, for example, and more preferably 3 nm to 20 nm.

[Hole Transport Layer 15, 25]

The hole transport layers 15 and 25 are layers having a function of transporting charges. For example, conductors, semiconductors, organic hole transport materials, and the like may be used for the hole transport layers 15 and 25. The organic hole transport materials may function as a hole transport material that receives holes from the perovskite layers (photoelectric conversion layers) 14 and 24 and transports the holes. Inorganic hole transport materials or the organic hole transport materials are used for the conductors and the semiconductors. Examples of the inorganic hole transport materials include compound semiconductors containing monovalent copper such as CuI, $CuInSe_2$, and CuS; compounds containing metals other than copper such as GaP, NiO, CuO, FeO, $Bi_2O_3$, $MoO_3$, and $Cr_2O$, and the like. The inorganic hole transport material is preferably a semiconductor containing monovalent copper, and more preferably CuI or CuSCN, from the viewpoint of more efficiently receiving only holes and achieving higher hole mobility. Examples of the organic hole transport materials include polythiophene derivatives such as poly-3-hexylthiophene (P3HT) and polyethylenedioxythiophene (PEDOT); fluorene derivatives such as 2,2',7,7'-tetrakis-(N,N-di-p-methoxyphenylamine)-9,9'-spirobifluorene (Spiro-OMeTAD); carbazole derivatives such as polyvinylcarbazole; triphenylamine derivatives such as poly[bis(4-phenyl)(2,4,6-trimethylphenyl)amine] (PTAA); diphenylamine derivatives; polysilane derivatives; polyaniline derivatives, and the like. The organic hole transport material is preferably triphenylamine derivatives, fluorene derivatives, and the like, and more preferably PTAA, Spiro-OMeTAD, and the like, from the viewpoint of more efficiently receiving only holes and achieving higher hole mobility.

Furthermore, the organic hole transport material may also include oxidizing agents such as lithium bis(trifluoromethylsulfonyl)imide (LiTFSI), silver bis(trifluoromethylsulfonyl)imide, zinc bis(trifluoromethylsulfonyl)imide, ammonium bis(trifluoromethanesulfonyl)imide, lithium bis(nonafluorobutanesulfonyl)imide, sodium bis(nonafluorobutanesulfonyl) imide, lithium nonafluoro-N-[(trifluoromethane)sulfonyl]butanesulfonylamide, potassium nonafluoro-N-[(trifluoromethane)sulfonyl]butanesulfonylamide, nonafluoro-N-[(trifluoromethane)sulfonyl]butanesulfonylamide, lithium N,N-hexafluoro-1,3-disulfonylimide, sodium N,N-hexafluoro-1,3-disulfonylimide, trifluoromethylsulfonyloxy silver, $NOSbF_6$, $SbCl_5$, $SbF_5$, and tris(2-(1H-pyrazol-1-yl)-4-tert-butylpyridine)cobalt(III) tri[bis(trifluoromethane)sulfonimide], for the purpose of further improving hole transport characteristics. In addition, the hole transport layers 15 and 25 may also include

basic compounds such as tert-butylpyridine (TBP), 2-picoline, and 2,6-lutidine. The contents of the oxidizing agents and basic compounds may be, for example, amounts conventionally and commonly used. The film thickness of the hole transport layers 15 and 25 is preferably, for example, 1 nm to 500 nm, and more preferably 2 nm to 300 nm, from the viewpoint of more efficiently receiving only holes and achieving higher hole mobility. The method for forming the hole transport layers 15 and 25 is preferably performed, for example, under dry atmosphere. For example, it is preferable to apply (spin coating or the like) a solution containing an organic hole transport material onto the perovskite layer (light absorption layer) under dry atmosphere and heat at 30°C to 180°C, particularly 100°C to 150°C.

In addition, as the hole transport layer 25 in the inverted structure, it is also possible to use, for example, a hole transport compound that forms a molecular layer (hereinafter also referred to as "molecular hole transport compound"). The molecular hole transport compound desirably has an anchor that chemically bonds with ITO or the like, which is a transparent electrode, in the inverted structure. Examples of the anchor include a phosphonic acid group ($-P=O(OH)_2$), a carboxy group (-COOH), a sulfo group ($-SO_3H$), a boronic acid group ($-B(OH)_2$), a trihalogenated silyl group ($-SiX_3$, where X is a halogen atom), or a trialkoxysilyl group ($-Si(OR)_3$, where R is an alkyl group), and salts of these may also be formed. Examples of salts include salts with alkali metals such as potassium and sodium, and quaternary ammonium salts such as tetramethylamine and tetra-n-butylamine. Among these, a phosphonic acid group, a trihalogenated silyl group, and a trialkoxysilyl group are particularly preferable.

The molecular hole transport compound may include a compound represented by the following chemical formula (4).

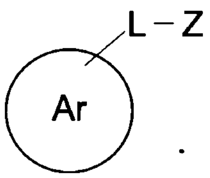

. . . (4)

In the chemical formula (4), Ar is a structure including an aromatic ring, and may or may not include a hetero atom among the atoms constituting the aromatic ring, Ar may or may not have a substituent other than -L-Z, -L-Z may be one or more, and in the case of more than one, each L and each Z may be the same as or different from each other, each L is an atomic group that bonds Ar and Z, or is a covalent bond, and each Z is a group capable of transferring charges with the first electrode. The number of -L-Z is not particularly limited, but may be, for example, in the range of 1 to 4.

In the photoelectric conversion element of the disclosure, in the chemical formula (4), the L may include, for example, divalent substituents such as divalent alkylene groups like 1,1-methylene group and 1,2-ethylene group, and divalent alkoxy groups like diethoxyethane, and these may or may not have substituents other than the Z.

In the photoelectric conversion element of the disclosure, in the chemical formula (4), each Z may be a phosphonic acid group ($-P=O(OH)_2$), a carboxy group (-COOH), a sulfo group ($-SO_3H$), a boronic acid group ($-B(OH)_2$), a trihalogenated silyl group ($-SiX_3$, where X is a halo group), or a trialkoxysilyl group ($-Si(OR)_3$, where R is an alkyl group), respectively.

Specific examples of the molecular hole transport material include compounds represented by the following (A-01) to (A-30), but are not limited thereto.

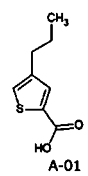
A-01
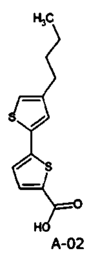
A-02
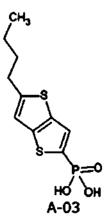
A-03
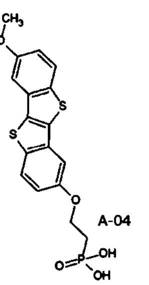
A-04

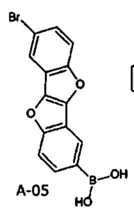
A-05
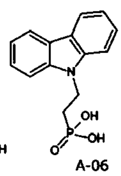
A-06
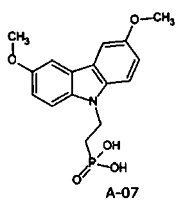
A-07

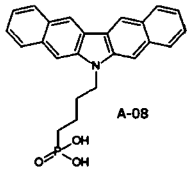
A-08

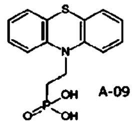
A-09

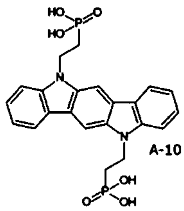
A-10

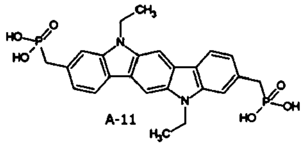
A-11

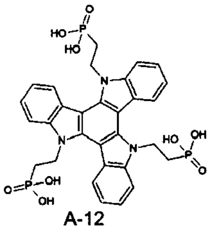
A-12

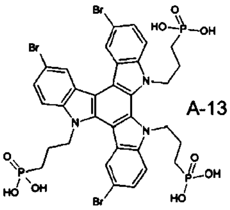
A-13

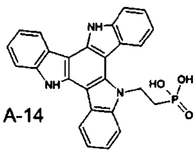
A-14

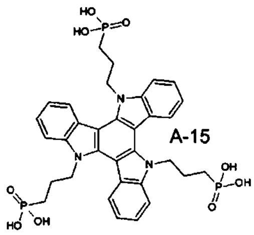
A-15

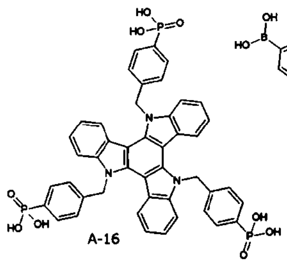
A-16

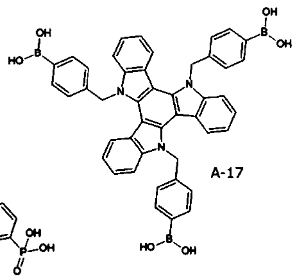
A-17

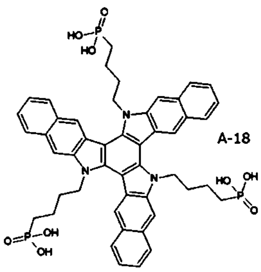
A-18

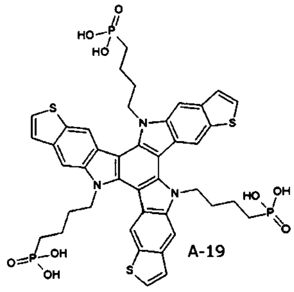
A-19

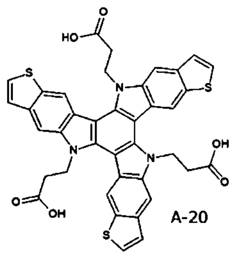
A-20

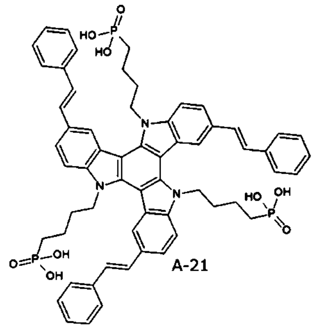
A-21

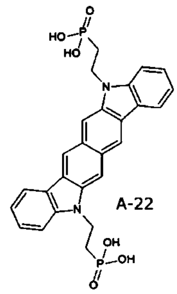
A-22

A-23
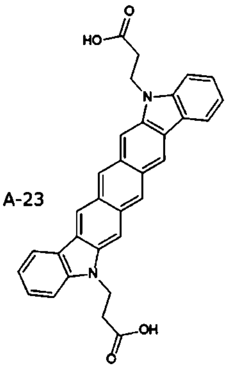

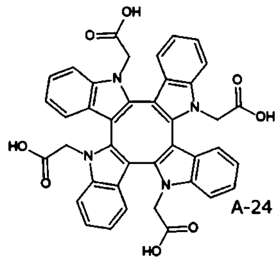
A-24

A-25
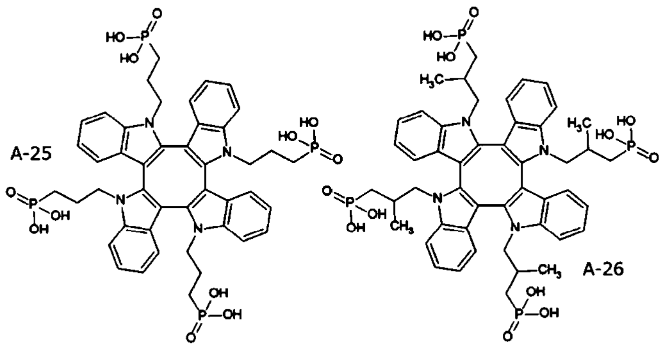
A-26

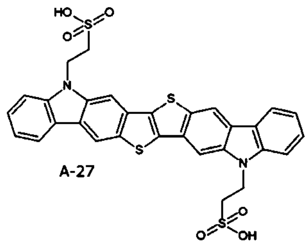
A-27

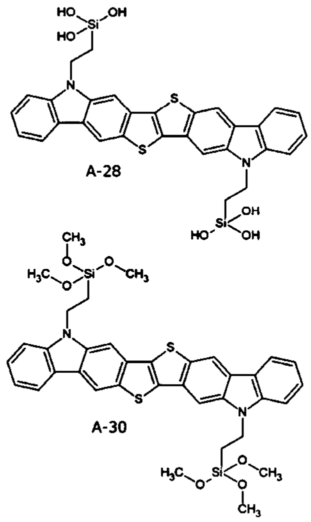
A-28

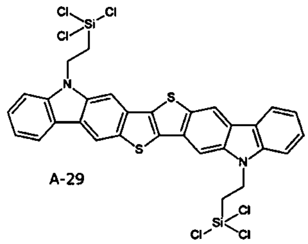
A-29

A-30

In the molecular hole transport material, two or more substituents L-Z are preferable, and three or more are more preferable.

The formation method of the hole transport layer 25 using the molecular hole transport material is not particularly limited, but for example, the hole transport layer 25 may be formed by adsorbing the molecular hole transport compound to the first electrode 22 to form a molecular layer. The method of adsorbing the molecular hole transport compound to the first electrode 22 to form a molecular layer is not particularly limited, but for example, the molecular hole transport compound may be dissolved in a solvent and brought into contact with the first electrode 22 for bonding. The bonding between the molecular hole transport compound and the first electrode 22 is not particularly limited, and may be physical bonding or chemical bonding. The type of the bonding is not particularly limited either, and may be any of hydrogen bonding, ester bonding, chelate bonding, and the like. The solvent for dissolving the molecular hole transport compound is not particularly limited either, and may be, for example, one or both of water and an organic solvent. More specifically, examples of the solvent include water; alcohols such as methanol, ethanol, and 2-propanol; ethers such as diethyl ether and diisopropyl ether; ketones such as acetone and methyl isobutyl ketone; esters such as ethyl acetate, isobutyl acetate, and γ-butyrolactone; heterocycles such as tetrahydrofuran and thiophene; amides such as N,N-dimethylformamide, N,N-dimethylacetamide, and N-methylpyrrolidone; sulfoxides such as dimethyl sulfoxide; sulfones such as diethyl sulfone and sulfolane; nitriles such as acetonitrile and 3-methoxypropionitrile; aromatic compounds such as benzene, toluene, and chlorobenzene; halogen-based solvents such as dichloromethane and chloroform; and fluorine-based solvents such as chlorofluorocarbon, hydrochlorofluorocarbon, and hydrofluorocarbon, which may be used alone or in a mixture of two or more types.

The specific method for adsorbing the molecular hole transport compound to the first electrode 22 to form a molecular layer is not particularly limited, and examples include known methods such as dipping method, spray method, spin coating method, and bar coating method. The temperature during adsorption is not particularly limited, but is preferably -20°C to 100°C, and more preferably 0°C to 50°C. The adsorption time is not particularly limited either, but is preferably 1 second to 48 hours, for example, and more preferably 10 seconds to 1 hour. In addition, after the adsorption treatment, washing may or may not be performed, for example. The washing method is not particularly limited either, and known methods may be appropriately used, for example.

After the adsorption treatment or after the washing, heat treatment may or may not be performed. The temperature of the heat treatment is preferably 50°C to 150°C, and more preferably 70°C to 120°C. The heat treatment time is preferably 1 second to 48 hours, and more preferably 10 seconds to 1 hour. The heat treatment may be performed, for example, under atmospheric conditions or in vacuum.

In adsorbing the molecular hole transport compound to the first electrode 22, for example, a co-adsorbent may or may not be used in combination. The co-adsorbent may be added, for example, in the case where the electrode surface cannot be completely covered with the molecular hole transport compound alone, or for the purpose of inhibiting interactions between the molecular hole transport compounds.

The co-adsorbent is not particularly limited, and examples include phosphonic acid compounds such as n-butylphosphonic acid, n-hexylphosphonic acid, n-decylphosphonic acid, n-octadecylphosphonic acid, 2-ethylhexylphosphonic acid, methoxymethylphosphonic acid, 3-acryloyloxypropylphosphonic acid, 11-hydroxyundecylphosphonic acid, and 1H,1H,2H,2H-perfluorophosphonic acid, as well as acetic acid, propionic acid, isobutyric acid, nonanoic acid, fluoroacetic acid, α-chloropropionic acid, glyoxylic acid, chenodeoxycholic acid, and the like. These may be used alone or in a mixture of two or more types.

The method for adsorbing the co-adsorbent to the first electrode 22 is not particularly limited, but similar to the molecular hole transport compound, a method of dissolving the co-adsorbent in a solvent before adsorption is preferable. The solvent is not particularly limited either, but may be, for example, the same as the aforementioned solvents exemplified for the molecular hole transport compound. In addition, the co-adsorbent may be adsorbed by immersing the first electrode 22 in a solvent in which the co-adsorbent has been dissolved after the molecular hole transport compound has been adsorbed to the substrate, or may be mixed and dissolved in an organic solvent together with the molecular hole transport compound.

Further, in the disclosure, in the case where isomers such as tautomers or stereoisomers (for example, geometric isomers, conformational isomers, and optical isomers) exist for a compound, any isomer may be used in the disclosure unless otherwise specified. Furthermore, in the disclosure, in the case where a compound can form a salt, the salt may also be used in the disclosure unless otherwise specified. The salt may be an acid addition salt or a base addition salt. Additionally, the acid forming the acid addition salt may be an inorganic acid or an organic acid, and the base forming the base addition salt may be an inorganic base or an organic base. The inorganic acid is not particularly limited, and examples include sulfuric acid, phosphoric acid, hydrofluoric acid, hydrochloric acid, hydrobromic acid, hydroiodic acid, hypofluorous acid, hypochlorous acid, hypobromous acid, hypoiodous acid, fluorous acid, chlorous acid, bromous acid, iodous acid, fluoric acid, chloric acid, bromic acid, iodic acid, perfluoric acid, perchloric acid, perbromic acid, periodic acid, and the like. The organic acid is not particularly limited, and examples include p-toluenesulfonic acid, methanesulfonic acid, oxalic acid, p-bromobenzenesulfonic acid, carbonic acid, succinic acid, citric acid, benzoic acid, acetic acid, and the like. The inorganic base is not particularly limited, and examples include ammonium hydroxide, alkali metal hydroxides, alkaline earth metal hydroxides, carbonates, and hydrogen carbonates, and more specific examples include sodium hydroxide, potassium hydroxide, potassium carbonate, sodium carbonate, sodium hydrogen carbonate, potassium hydrogen carbonate, calcium hydroxide, calcium carbonate, and the like. The organic base is not particularly limited either, and examples include ethanolamine, triethylamine, and tris(hydroxymethyl)aminomethane. The production method of these salts is not particularly limited either, and these salts may be produced, for example, by appropriately adding the aforementioned acids or bases to the compound by known methods.

Furthermore, the organic hole transport material may include oxidizing agents such as lithium bis(trifluoromethylsulfonyl)imide (LiTFSI), silver bis(trifluoromethylsulfonyl)imide, zinc bis(trifluoromethylsulfonyl)imide, ammonium bis(trifluoromethanesulfonyl)imide, lithium bis(nonafluorobutanesulfonyl)imide, sodium bis(nonafluorobutanesulfonyl) imide, lithium nonafluoro-N-[(trifluoromethane)sulfonyl]butanesulfonylamide, potassium nonafluoro-N-[(trifluoromethane)sulfonyl]butanesulfonylamide, nonafluoro-N-[(trifluoromethane)sulfonyl]butanesulfonylamide, lithium N,N-hexafluoro-1,3-disulfonylimide, sodium N,N-hexafluoro-1,3-disulfonylimide, trifluoromethylsulfonyloxy silver, $NOSbF_6$, $SbCl_5$, $SbF_5$, tris(2-(1H-pyrazol-1-yl)-4-tert-butylpyridine)cobalt(III) tri[bis(trifluoromethane)sulfonimide], for the purpose of further improving hole transport characteristics. In addition, the hole transport layers 15 and 25 may also include basic compounds such as tert-butylpyridine (TBP), 2-picoline, and 2,6-lutidine. The contents of the oxidizing agents and the basic compounds may be, for example, amounts conventionally and commonly used. The film thickness of the hole transport layers 15 and 25 is preferably, for example, 1 nm to 500 nm, and more preferably 2 nm to 300 nm, from the viewpoint of more efficiently receiving only holes and achieving higher hole mobility. The method for forming the hole transport layers 15 and 25 is preferably performed, for example, under dry atmosphere. The method for forming the hole transport layers 15 and 25 preferably includes, for example, applying (spin coating or the like) a solution containing an organic hole transport material onto the perovskite layer (light absorption layer) under dry atmosphere and heating at 30°C to 180°C, particularly 100°C to 150°C.

[Photoelectric Conversion Layer 14, 24]

The photoelectric conversion layers 14 and 24 are not particularly limited and may be, for example, the same as photoelectric conversion layers used in the photoelectric conversion elements such as general solar cells. The photoelectric conversion layers 14 and 24 include, for example, a perovskite compound. The perovskite compound may be, for example, a compound represented by the following chemical formula (5).

$$A_\alpha B_\beta C_\gamma \qquad (5)$$

In the chemical formula (5), the ratio of $\alpha:\beta:\gamma$ is, for example, 3:1:1, where A represents a halogen ion, B represents a monovalent cation, and C represents a divalent cation. The perovskite layer is preferably disposed adjacent to the electron transport layer. It is noted that the ratio of $\alpha:\beta:\gamma$ is not necessarily 3:1:1, and may be, for example, 3:1.05:0.95 or 3:0.95:1.05. The ratio of $\alpha:\beta:\gamma$ is, for example, 3:(0.95 to 1.05):(0.95 to 1.05).

In the chemical formula (5), A is not particularly limited and may be appropriately selected according to the purpose, and examples include halogen ions such as chlorine, bromine, and iodine. The halogen ions may be used alone or in combination of two or more types.

In the chemical formula (5), examples of B include alkylamine compound ions (organic compounds having amino groups) such as methylammonium cation, ethylammonium cation, n-butylammonium cation, and formamidinium cation, and alkali metal ions such as cesium cation, potassium cation, and rubidium cation, without being limited to organic compounds. The alkylamine compound ions and the alkali metal ions may respectively be used alone or in combination of two or more types. Further, organic (alkylamine compound ions) and inorganic (alkali metal ions) may be used in combination, and for example, cesium ion and formamidine may be used in combination.

In the chemical formula (5), C is not particularly limited and may be appropriately selected according to the purpose, and examples include divalent metal ions such as lead, indium, antimony, tin, copper, bismuth, and germanium. The divalent metal ions may be used alone or in combination of two or more types. Among the divalent metal ions, lead is particularly preferable, and the combination of lead and tin is especially preferable.

The photoelectric conversion layers 14 and 24 may be formed from a perovskite compound as described above. The methods for forming the perovskite layer are not particularly limited and may be appropriately selected according to the purpose, and examples include a method of applying a solution in which a metal halide and an alkylamine halide are dissolved or dispersed, followed by drying.

Additionally, the methods for forming the perovskite layer include, for example, a two-step precipitation method in which a solution having a metal halide dissolved or dispersed therein is applied and dried, and then immersed in a solution having an alkylamine halide dissolved therein to form a perovskite compound.

Other methods for forming the perovskite layer include, for example, a method of precipitating crystals by adding a poor solvent (a solvent with low solubility) for the perovskite compound while applying a solution having a metal halide and an alkylamine halide dissolved or dispersed therein. Additionally, other methods for forming the perovskite layer include, for example, a method of vapor-depositing a metal halide in a gas filled with methylamine or the like.

Among the methods for forming the perovskite layer, the method of precipitating crystals by adding a poor solvent for the perovskite compound while applying a solution having a metal halide and an alkylamine halide dissolved or dispersed therein is particularly preferable. The method for applying the solution is not particularly limited and may be appropriately selected according to the purpose, and examples include immersion method, spin coating method, spray method, dip method, roller method, air knife method, and the like. Additionally, the method for applying the solution may be, for example, a method of precipitating in a supercritical fluid using carbon dioxide or the like. In the method of adding the poor solvent to precipitate crystals, examples of the poor solvent include hydrocarbons such as n-hexane and n-octane; alcohols such as methanol, ethanol, and 2-propanol; ethers such as diethyl ether and diisopropyl ether; ketones such as acetone and methyl isobutyl ketone; esters such as ethyl acetate, isobutyl acetate, and γ-butyrolactone; nitriles such as acetonitrile and 3-methoxypropionitrile; aromatic hydrocarbon compounds such as benzene, toluene, and chlorobenzene; halogen-based solvents such as dichloromethane and chloroform; and fluorine-based solvents such as chlorofluorocarbon, hydrochlorofluorocarbon, and hydrofluorocarbon.

The method for forming the perovskite layer may further include, for example, a step for removing solvent after forming the perovskite layer (solvent removal step) or a step for arranging perovskite crystals (crystal arrangement step). The solvent removal step and the crystal arrangement step may include, for example, a method of blowing dry air or the like, a method of heating with a hot plate or oven, a method of vacuum drying, and the like. In the solvent removal step and the crystal arrangement step, the heating temperature is preferably 50°C to 200°C, and more preferably 70°C to 180°C. In the solvent removal step and the crystal arrangement step, the heating time is preferably 1 minute to 150 minutes, and more preferably 5 minutes to 60 minutes. In addition, the thickness of the photoelectric conversion layers 14 and 24 is not particularly limited, but from the viewpoint of further suppressing performance degradation due to defects or peeling, the thickness is preferably 50 nm to 1500 nm, and more preferably 200 nm to 1000 nm.

The method for forming the perovskite layer may include, for example, a step of surface treatment using a salt formed from one or more cations and one or more anions (surface treatment step). Examples of the cations include inorganic cations such as lithium, sodium, potassium, rubidium, cesium, magnesium, and calcium; organic compounds having amino groups such as ammonium cation, methylamine, ethylamine, n-butylamine, isopentylamine, neopentylamine, formamidine, acetamidine, benzylamine, 2-phenylethylamine, 2-(4-methoxyphenyl)ethylamine, 4-fluorobenzylamine, 2-(4-fluorophenyl)ethylamine, 1,4-phenylenediamine, 5-aminovaleric acid, metamine, ethylenediamine, p-xylylenediamine, m-xylylenediamine, 1,2-adamantanediamine, 1,3-adamantanediamine, N,N-dimethylethylenediamine, 1,3-diaminopropane, 1,4-diazabicyclo[2.2.2]octane, guanidine, aniline, pyrrole, imidazole, 1-ethylimidazole, 2-ethylimidazole, benzimidazole, morpholine, pyrrolidine, pyrazole, triazole, and carbazole; cations obtained from heterocycles containing nitrogen atoms such as pyridine, pyrazine, pyridazine, pyrimidine, quinoline, isoquinoline, phenanthroline, 2,2'-bipyridyl, and 4,4'-bipyridyl, and the like. Examples of the anions include halogen ions such as fluorine ion, chlorine ion, bromine ion, and iodine ion; carboxylic acid ions such as formate ion and acetate ion; isocyanate ion, thiocyanate ion, tetrafluoroborate ion, hexafluorophosphate ion; trifluoromethanesulfonylimide ion, and the like.

The salt composed of the cations and the anions is preferably dissolved in, for example, one or more solvents. Examples of the solvents include alcohols such as isopropanol (2-propanol), ethanol (EtOH), methanol (MeOH), and n-butanol; nitriles such as acetonitrile and propionitrile; aromatic solvents such as toluene, chlorobenzene, and 1,2-dichlorobenzene, and the like. The solvents may be used alone or in combination of two or more types.

The surface treatment step is performed by applying a solution in which the salt is dissolved onto the formed perovskite layer and drying. The method for applying the solution is not particularly limited and may be appropriately selected according to the purpose, and examples include immersion method, spin coating method, spray method, dip method, roller method, air knife method, and the like. In the surface treatment step, heat treatment may be performed after the application, and in the case of heating, the heating temperature is preferably 50°C to 200°C, and more preferably 70°C to 180°C. The heating time is preferably 1 minute to 150 minutes, and more preferably 5 minutes to 60 minutes. The film thickness for applying the solution is not particularly limited.

[Second Electrode 16, 26]

The second electrodes 16 and 26 (which may be, for example, back electrodes) are each a layer having a function of extracting holes or electrons from the photoelectric conversion layers 14 and 24 via the hole transport layer or the electron transport layer, for example.

The second electrodes 16 and 26 may be formed directly on the hole transport layer 15 in the case of the normal structure, and may be formed directly on the electron transport layer 23 in the case of the inverted structure. In addition, the material of the second electrodes 16 and 26 is not particularly limited, and for example, the same material as the first electrodes 12 and 22 may be used. The shapes, structures, and sizes of the second electrodes 16 and 26 are not particularly limited and may be appropriately selected according to the purpose. Examples of the material of the second electrodes 16 and 26 include metals, carbon compounds, conductive metal oxides, conductive polymers, and the like. Examples of the metals include platinum, gold, silver, copper, aluminum, and the like. Examples of the carbon compounds include graphite, fullerene, carbon nanotubes, graphene, and the like. Examples of the conductive metal oxides include ITO, IZO, FTO, ATO, and the like. Examples of the conductive polymers include polythiophene, polyaniline, and the like. In addition, the material used for forming the second electrodes 16 and 26 may be used alone or in combination of two or more types.

The second electrodes 16 and 26 may be formed by appropriately using methods such as coating, laminating, vacuum deposition, CVD, sputtering, and bonding on the hole transport layer 15 or the electron transport layer 23, depending on the type of the material used and the type of the hole transport layer 15 or the electron transport layer 23.

Furthermore, the configuration of the photoelectric conversion element of the disclosure is not limited to the configuration of FIG. 2 or FIG. 3. For example, the support 11 may be disposed on the opposite side from FIG. 2 (upper side of the second electrode 16 in FIG. 2), and the second electrode 16, the electron transport layer 15, the photoelectric conversion layer 14, the hole transport layer 13, and the first electrode 12 may be laminated in this order on the support 11. Further, for example, as described above, other components may or may not be present between the layers of the support 11, the first electrode 12, the hole transport layer 13, the photoelectric conversion layer 14, the electron transport layer 15, and the second electrode 16. Although the example illustrates that the first electrode 12 is a transparent electrode and the second electrode 16 is a back electrode, the photoelectric conversion element of the disclosure is not limited thereto. For example, in the photoelectric conversion element of the disclosure, conversely, the first electrode may be a back electrode and the second electrode may be a transparent electrode.

The total thickness of the photoelectric conversion element of the disclosure may be appropriately changed according to the thickness of the support used.

[Sealing]

The photoelectric conversion element (for example, solar cell) of the disclosure is preferably sealed to protect the device from water and oxygen. The sealing structure is not particularly limited, and may be the same as, for example, the sealing structure for a general photoelectric conversion element (for example, solar cell). Specifically, for example, the sealing member may be applied only to the outer peripheral portion of the photoelectric conversion element of the disclosure and covered with glass or film, the sealing member may be applied to the entire surface of the photoelectric conversion element of the disclosure and covered with glass or film, or only the sealing member may be applied to the entire surface of the photoelectric conversion element of the disclosure.

The material of the sealing member is not particularly limited and may be appropriately selected according to the purpose. For example, it is preferable to use epoxy resin or acrylic resin for curing, but the resin may not be cured or may be cured partially.

The epoxy resin is not particularly limited, and examples include water-dispersed type, solvent-free type, solid type, thermosetting type, curing agent mixing type, ultraviolet curing type, and the like. Among these, thermosetting type and ultraviolet curing type are preferable, and ultraviolet curing type is more preferable. It is noted that even in the case of the epoxy resin being ultraviolet curing type, heating may be performed, and it is preferable to perform heating even after ultraviolet curing. Specific examples of the epoxy resin include bisphenol A type, bisphenol F type, novolac type,

cycloaliphatic type, long-chain aliphatic type, glycidylamine type, glycidyl ether type, glycidyl ester type, and the like. These may be used alone or in combination of two or more types. Moreover, it is preferable to mix a curing agent and various additives with the epoxy resin as required. Commercially available epoxy resin compositions may be used in the disclosure. Examples of the commercially available epoxy resin compositions include epoxy resin compositions developed and commercially available for solar cell and organic EL element applications, which may be used particularly effectively in the disclosure. Examples of the commercially available epoxy resin compositions include TB3118, TB3114, TB3124, TB3125F (manufactured by ThreeBond Co., Ltd.), WorldRock5910, WorldRock5920, WorldRock8723 (manufactured by Kyoritsu Chemical & Co., Ltd.), WB90US(P), WB90US-HV (manufactured by Moresco Corporation), and the like.

The acrylic resin is not particularly limited, and for example, acrylic resin compositions developed and commercially available for solar cell and organic EL element applications may be effectively used. Examples of the commercially available acrylic resin compositions include TB3035B and TB3035C (manufactured by ThreeBond Co., Ltd.), and the like.

The curing agent is not particularly limited and may be appropriately selected according to the purpose. Examples include amine-based, acid anhydride-based, polyamide-based, and other curing agents. Examples of the amine-based curing agent include aliphatic polyamines such as diethylenetriamine and triethylenetetramine; aromatic polyamines such as metaphenylenediamine, diaminodiphenylmethane, and diaminodiphenylsulfone, and the like. Examples of the acid anhydride-based curing agent include phthalic anhydride, tetra- and hexahydrophthalic anhydride, methyltetrahydrophthalic anhydride, methylnadic anhydride, pyromellitic anhydride, het anhydride, dodecenylsuccinic anhydride, and the like. Examples of the other curing agents include imidazoles, polymercaptans, and the like. The curing agents may be used alone or in combination of two or more types.

The additives are not particularly limited and may be appropriately selected according to the purpose. Examples include filler, gap agent, polymerization initiator, desiccant (moisture absorber), curing accelerator, coupling agent, flexibilizer, colorant, flame retardant aid, antioxidant, organic solvent, and the like. Filler, gap agent, curing accelerator, polymerization initiator, and desiccant (moisture absorber) are preferable, and filler and polymerization initiator are more preferable. Including filler as the additive makes it possible to achieve effects such as suppressing the intrusion of moisture and oxygen, further reducing volume shrinkage during curing, reducing the amount of outgas during curing or heating, improving mechanical strength, and controlling thermal conductivity and fluidity. Therefore, including filler as the additive is very effective for maintaining stable output in various environments.

Further, regarding the output characteristics and durability of the photoelectric conversion element, the influence of intruding moisture and oxygen as well as the influence of outgas generated during curing or heating of the sealing member cannot be ignored. In particular, the influence of outgas generated during heating has a significant impact on output characteristics during storage in high-temperature environments. By including the filler, the gap agent, and the desiccant in the sealing member, these components themselves can suppress the intrusion of moisture and oxygen, and further, the amount of sealing member used can be reduced to achieve the effect of reducing outgas. Including the filler, the gap agent, and the desiccant in the sealing member is effective not only during curing but also during storage of the photoelectric conversion element in high-temperature environments.

The filler is not particularly limited and may be appropriately selected according to the purpose. Examples include inorganic fillers such as crystalline or amorphous silica, silicate minerals such as talc, alumina, aluminum nitride, silicon nitride, calcium silicate, calcium carbonate, and the like. Hydrotalcite is particularly preferable. The filler may be used alone or in combination of two or more types.

The average primary particle size of the filler is not particularly limited, but is preferably 0.1 μm or more and 10 μm or less, and more preferably 1 μm or more and 5 μm or less. In the case of the average primary particle size of the filler being within the above preferable range, the effect of suppressing the intrusion of moisture and oxygen can be sufficiently achieved, the viscosity becomes appropriate, adhesion to the substrate and defoaming properties are improved, and it is also effective for controlling the width of the sealing part and workability.

The content of the filler is preferably 10 parts by mass or more and 90 parts by mass or less, and more preferably 20 parts by mass or more and 70 parts by mass or less, with respect to the entire sealing member (100 parts by mass). In the case of the content of the filler being within the above preferable range, the effect of suppressing the intrusion of moisture and oxygen can be sufficiently achieved, the viscosity also becomes appropriate, and adhesion and workability also improve.

The gap agent is also called a gap control agent or spacer agent. Including the gap agent as the additive makes it possible to control the gap of the sealing part. For example, in the case of applying a sealing member on the substrate or first electrode, placing a second substrate thereon, and performing sealing, since the sealing member is mixed with the gap agent, the gap of the sealing part aligns with the size of the gap agent, thereby enabling easy control of the gap of the sealing part.

The gap agent is not particularly limited, but for example, gap agents that are granular with uniform particle size and have high solvent resistance and heat resistance are preferable, and may be appropriately selected according to the

purpose. The gap agent preferably has high affinity with epoxy resin and has a spherical particle shape. Specifically, the gap agent is preferably glass beads, silica fine particles, organic resin fine particles, and the like. The gap agent may be used alone or in combination of two or more types. The particle size of the gap agent may be selected according to the gap of the sealing part to be set, but is preferably 1 μm or more and 100 μm or less, and more preferably 5 μm or more and 50 μm or less.

The polymerization initiator is not particularly limited, and examples include polymerization initiators that initiate polymerization using heat or light, and may be appropriately selected according to the purpose, such as thermal cationic polymerization initiators and photocationic polymerization initiators. The thermal polymerization initiator is a compound that generates active species such as radicals or cations by heating, and examples include azo compounds such as 2,2'-azobisisobutyronitrile (AIBN), peroxides such as benzoyl peroxide (BPO), and the like. For example, benzenesulfonic acid esters, alkylsulfonium salts, and the like are used as the thermal cationic polymerization initiator. For example, the photocationic polymerization initiator is preferably used in the case of the photocationic polymerization initiator being epoxy resin. In the case of mixing the photocationic polymerization initiator with epoxy resin and performing light irradiation, the photocationic polymerization initiator decomposes to generate acid, the acid causes polymerization of the epoxy resin, and the curing reaction proceeds. The photocationic polymerization initiator has effects such as small volume shrinkage during curing, no oxygen inhibition, and high storage stability.

Examples of the photocationic polymerization initiator include aromatic diazonium salts, aromatic iodonium salts, aromatic sulfonium salts, metallocene compounds, silanol-aluminum complexes, and the like. A photoacid generator having a function of generating acid by light irradiation may also be used as the polymerization initiator. The photoacid generator acts as an acid that initiates cationic polymerization, and examples include ionic onium salts such as sulfonium salt-based and iodonium salt-based compounds composed of a cation part and an anion part. The photoacid generator may be used alone or in combination of two or more types.

The addition amount of the polymerization initiator is not particularly limited and may vary depending on the material used, but is preferably 0.5 parts by mass or more and 10 parts by mass or less, and more preferably 1 part by mass or more and 5 parts by mass or less, with respect to the entire sealing member (100 parts by mass). In the case of the addition amount being within the above preferable range, curing proceeds appropriately, residual uncured material can be reduced, and excessive outgas can be prevented.

The desiccant (also called a moisture absorber) is a material having a function of physically or chemically adsorbing and absorbing moisture. Including the desiccant in the sealing member makes it possible to further enhance moisture resistance and reduce the influence of outgas. The desiccant is not particularly limited and may be appropriately selected according to the purpose, but the desiccant is preferably in a particulate form. Examples include inorganic water-absorbing materials such as calcium oxide, barium oxide, magnesium oxide, magnesium sulfate, sodium sulfate, calcium chloride, silica gel, molecular sieves, and zeolite, with zeolite having a large moisture absorption capacity being preferable. The desiccant may be used alone or in combination of two or more types.

The curing accelerator (also called a curing catalyst) is a material that accelerates the curing rate and is mainly used for thermosetting epoxy resin. The curing accelerator is not particularly limited and may be appropriately selected according to the purpose. Examples include tertiary amines or tertiary amine salts such as DBU (1,8-diazabicyclo(5,4,0)-undecene-7) and DBN (1,5-diazabicyclo(4,3,0)-nonene-5); imidazole-based compounds such as 1-cyanoethyl-2-ethyl-4-methylimidazole and 2-ethyl-4-methylimidazole; phosphines or phosphonium salts such as triphenylphosphine and tetraphenylphosphonium tetraphenylborate, and the like. The curing accelerator may be used alone or in combination of two or more types.

The coupling agent is not particularly limited as long as the coupling agent is a material having an effect of enhancing molecular bonding force, and may be appropriately selected according to the purpose. Examples include silane coupling agents and the like. Specific examples of the coupling agent include 3-glycidoxypropyltrimethoxysilane, 3-glycidoxypropylmethyldimethoxysilane, 3-glycidoxypropylmethyldimethoxysilane, 2-(3,4-epoxycyclohexyl)ethyltrimethoxysilane, N-phenyl-γ-aminopropyltrimethoxysilane, N-(2-aminoethyl)3-aminopropylmethyldimethoxysilane, N-(2-aminoethyl)3-aminopropylmethyltrimethoxysilane, 3-aminopropyltriethoxysilane, 3-mercaptopropyltrimethoxysilane, vinyltrimethoxysilane, N-(2-(vinylbenzylamino)ethyl)3-aminopropyltrimethoxysilane hydrochloride, 3-methacryloxypropyltrimethoxysilane, and the like. The coupling agent may be used alone or in combination of two or more types.

In the disclosure, for example, a sheet-like adhesive may be used. The sheet-like adhesive is, for example, an adhesive with a resin layer formed in advance on a sheet, and glass or a film with high gas barrier properties may be used for the sheet. The sheet may also be formed only with sealing resin. The sheet-like adhesive may also be attached onto a sealing film. It is also possible to provide a hollow structure on the sealing film and then bond the structure with a device.

In the case of sealing using the sealing film, the sealing film is disposed facing the support to sandwich a photoelectric conversion device. In the support of the sealing film, the shape, structure, size, and type are not particularly limited and may be appropriately selected according to the purpose. The sealing film forms a barrier layer on the surface of the support to prevent passage of moisture and oxygen, and may be formed on only one surface of the support or on both surfaces.

The barrier layer may include, for example, a material using a metal oxide, a metal, a mixture formed from a polymer and a metal alkoxide as a main component. Examples of the metal oxide include aluminum oxide, silicon oxide, aluminum, and the like. Examples of the polymer include polyvinyl alcohol, polyvinylpyrrolidone, methylcellulose, and the like. Examples of the metal alkoxide include tetraethoxysilane, triisopropoxyaluminum, 3-glycidoxypropyltrimethoxysilane, 3-mercaptopropyltrimethoxysilane, 3-isocyanatepropyltriethoxysilane, and the like.

The barrier layer may be, for example, transparent or opaque. Further, the barrier layer may be a single layer formed by a combination of the above materials or may have multiple laminated structures. The barrier layer may be formed by known methods, for example, coating methods such as vacuum film formation like sputtering method, dipping method, roll coating method, screen printing method, spray method, and gravure printing method.

[Wiring]

The photoelectric conversion element (for example, solar cell) of the disclosure preferably has lead wires (wiring) connected to the electrode and the back electrode in order to efficiently extract the current generated by light. The lead wires are connected to, for example, the first electrode and the second electrode using conductive materials such as solder, silver paste, and graphite. The conductive materials may be used alone or in a mixture or laminated structure of two or more types. In addition, the portions where the lead wires are attached may be covered with acrylic resin or epoxy resin from the viewpoint of physical protection.

The lead wires are a general term for electric wires used for electrically connecting power sources, electronic components, and the like in electric circuits, and examples include vinyl wires, enamel wires, and the like.

[Application]

The applications and usage methods of the photoelectric conversion element of the disclosure are not particularly limited, and the photoelectric conversion element may be widely used in applications similar to general photoelectric conversion elements (for example, general solar cells). The photoelectric conversion element (for example, solar cell) of the disclosure may be applied to power supply devices through combination with, for example, circuit boards that control the generated current. Examples of devices utilizing the power supply devices include electronic desktop calculators, solar radio-controlled wristwatches, and the like. It is also possible to apply the photoelectric conversion element of the disclosure as a power supply device for mobile phones, electronic paper, temperature and humidity meters, and the like. The photoelectric conversion element may also be applied to auxiliary power sources for extending the continuous usage time of rechargeable or dry battery-type electrical appliances, or for nighttime use through combination with secondary batteries. The photoelectric conversion element may also be used as a self-contained power source that does not require battery replacement or power wiring.

Examples

Examples of the disclosure will be described below. However, the disclosure is not limited to the following examples.

[Example 1]

On a 125 μm thick PET film, a 150 nm 10% tin-doped indium oxide (ITO) film was formed using sputtering. On this ITO film, 80 nm of indium oxide was formed also using sputtering. On the indium oxide, 1 mL of a DMF solution (0.1 mmol/L) in which the compound of the above formula (4) was dissolved was placed, and a monomolecular layer (hole transporter in the hole transport layer) was formed on the ITO (first electrode) using a spin coater (3,000 rpm, 30 seconds) and a hot plate (110°C, 10 minutes). Next, a solution obtained by diluting an alumina dispersion (dispersion with an average particle size of alumina of 50 nm, an alumina content of 20 wt%, and 2-propanol as a dispersion medium) 50-fold with 2-propanol was added in an amount of 0.1 mL on the hole transporter, and a hole transport layer in which the hole transport material and the insulating compound were mixed was formed using a spin coater (3,000 rpm, 30 seconds) and a hot plate (100°C, 15 minutes). Next, a solution in which cesium iodide (0.738 g), formamidine iodide (7.512 g), methylamine bromide (0.905 g), lead iodide (23.888 g), and lead bromide (1.022 g) were dissolved in DMF (40.0 mL) and dimethyl sulfoxide (DMSO, 12.0 mL) was formed into a film on the substrate using spin coating. For spin coating, chlorobenzene (0.3 mL) was dropped 30 seconds after the start at 3000 rpm. Thereafter, heating was performed at 150°C for 10 minutes to obtain a perovskite layer (photoelectric conversion layer). Subsequently, ethylenediamine dihydroiodide at 0.5 nm (interface layer), C60 at 20 nm (electron transport layer), bathocuproine (BCP, 8 nm) (electron injection layer), and Ag (100 nm) (second electrode) were formed into films by vacuum deposition to fabricate a photoelectric conversion element. After fabrication, the solar cell characteristics of the photoelectric conversion element were evaluated. The measurement results are shown in Table 1.

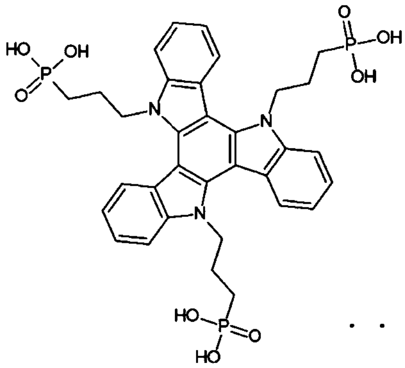

. . . (5)

The photoelectric conversion characteristics of the photoelectric conversion element fabricated in Example 1 were measured by a method based on the output measurement method for silicon crystalline solar battery cells of JIS C8913:1998. A solar simulator (SMO-250III manufactured by Bunko Keiki Co., Ltd.) combined with an air mass filter equivalent to AM1.5G was adjusted to a light intensity of 100 mW/$cm^2$ with a secondary standard Si solar cell to serve as a measurement light source, and I-V curve characteristics were measured using a source meter (Model 2400 general-purpose source meter manufactured by Keithley Instruments Inc.) while irradiating light onto a test sample of a perovskite solar cell (the photoelectric conversion element fabricated in Example 1). From the I-V curve characteristic measurement, short-circuit current (Isc), open-circuit voltage (Voc), fill factor (FF), short-circuit current density (Jsc), and photoelectric conversion efficiency (PCE) were determined.

In the following examples and comparative examples, solar cell characteristics were evaluated similarly.

Short-circuit current density (Jsc; mA/$cm^2$)=Isc (mA)/effective light-receiving area S ($cm^2$) Formula 1:

Photoelectric conversion efficiency (PCE; %)=Voc (V)$\times$Jsc (mA/$cm^2$)$\times$FF$\times$100/100 (mW/$cm^2$) Formula 2:

The doping concentration of the transparent conductive laminate in the obtained photoelectric conversion element was 10% for ITO and 0% for indium oxide. Additionally, FIG. 4 shows the measurement results of a single film of ITO formed on glass using a spectroscopic ellipsometer (SE-2100 manufactured by Semilab Inc., measurement wavelength: 245 nm to 2100 nm, spot diameter 500 μm, measurement incident angle 70°, integration time 2000 msec). The refractive index n value at 900 nm was 1.22. A single film of indium oxide was fabricated in the same manner as ITO, and measurement was performed using spectroscopic ellipsometer. The measurement results are shown in FIG. 5. From FIG. 5, the refractive index value at 900 nm was 1.86.

[Example 2]

A photoelectric conversion element was fabricated in the same manner as Example 1 except that the film thickness of indium oxide of 80 nm in Example 1 was changed to 120 nm, and solar cell characteristics were evaluated. The results are shown in Table 1.

[Example 3]

A photoelectric conversion element was fabricated in the same manner as Example 1 except that the film thickness of indium oxide of 80 nm in Example 1 was changed to 40 nm, and solar cell characteristics were evaluated. The results are shown in Table 1.

[Example 4]

A photoelectric conversion element was fabricated in the same manner as Example 1 except that the film thickness of indium oxide of 80 nm in Example 1 was changed to IWO 50 nm, and solar cell characteristics were evaluated. The results are shown in Table 1. Additionally, the spectroscopic ellipsometer measurement of IWO was performed in the same manner as ITO in Example 1. The result is shown in FIG. 6, and the refractive index of IWO at 900 nm was 1.94.

[Example 5]

A photoelectric conversion element was fabricated in the same manner as Example 1 except that the film thickness of IWO of 50 nm in Example 4 was changed to 25 nm, and solar cell characteristics were evaluated. The results are shown in Table 1.

[Example 6]

A photoelectric conversion element was fabricated in the same manner as Example 1 except that the film thickness of IWO of 50 nm in Example 4 was changed to 80 nm, and solar cell characteristics were evaluated. The results are shown in Table 1.

[Comparative Example 1]

A photoelectric conversion element was fabricated in the same manner as Example 1 except that the indium oxide film of 80 nm in Example 1 was not formed and an ITO single film was used, and solar cell characteristics were evaluated. The results are shown in Table 1.

[Comparative Example 2]

A photoelectric conversion element was fabricated in the same manner as Example 1 except that the ITO film of 150 nm in Comparative Example 1 was changed to an IWO film of 120 nm, and solar cell characteristics were evaluated. The results are shown in Table 1.

[Table 1]

| Example | First transparent conductive film 2a | | | | Second transparent conductive film 2b | | | | Voc V | Jsc $mA/cm^2$ | FF | PCE % |
|---|---|---|---|---|---|---|---|---|---|---|---|---|
| | Material | Doping concentration (D1) | Refractive index (N1) | Film thickness (T1) | Material | Doping concentration (D2) | Refractive index (N2) | Film thickness (T2) | | | | |
| 1 | ITO | 10% | 1.22 | 150 nm | Indium oxide | 0% | 1.86 | 80 nm | 1.11 | 23.5 | 0.82 | 21.4 |
| 2 | " | " | " | " | " | " | " | 120 nm | 1.09 | 23.3 | 0.81 | 20.6 |
| 3 | " | " | " | " | " | " | " | 40 nm | 1.11 | 23.4 | 0.81 | 21.0 |
| 4 | " | " | " | " | IWO | 5% | 1.94 | 50 nm | 1.11 | 22.9 | 0.81 | 20.6 |
| 5 | " | " | " | " | " | " | " | 25 nm | 1.09 | 23.1 | 0.80 | 20.1 |
| 6 | " | " | " | " | " | " | " | 80 nm | 1.10 | 23.1 | 0.80 | 20.3 |
| Comparative Example 1 | ITO | 10% | 1.22 | 150 nm | - | - | - | - | 1.06 | 22.4 | 0.75 | 17.8 |
| Comparative Example 2 | IWO | 5% | 1.94 | 100 nm | - | - | - | - | 1.02 | 20.2 | 0.68 | 14.0 |

[Example 7]

On a 125 μm thick PET film, a first transparent film composed of magnesium oxide (MgO) was formed as an optical adjustment film using sputtering such that the film thickness (T1) became 20 nm. On this first transparent film, indium oxide was formed to 250 nm as a second transparent film also using sputtering. On the indium oxide film of the transparent conductive film including the first transparent film and the second transparent film (on the surface of the indium oxide film), 1 mL of a DMF solution (0.1 mmol/L) in which the compound of the above formula (4) was dissolved was placed, and a monomolecular layer (hole transporter in the hole transport layer) was formed on the first transparent film (transparent conductive layer as the first electrode) using a spin coater (3,000 rpm, 30 seconds) and a hot plate (110°C, 10 minutes). Next, a solution obtained by diluting an alumina dispersion (dispersion with an average particle size of alumina of 50 nm, an alumina content of 20 wt%, and 2-propanol as a dispersion medium) 50-fold with 2-propanol was added in an amount of 0.1 mL on the hole transporter, and a hole transport layer in which the hole transport material and the insulating compound were mixed was formed using a spin coater (3,000 rpm, 30 seconds) and a hot plate (100°C, 15 minutes). Next, a solution in which cesium iodide (0.738 g), formamidine iodide (7.512 g), methylamine bromide (0.905 g), lead iodide (23.888 g), and lead bromide (1.022 g) were dissolved in DMF (40.0 mL) and dimethyl sulfoxide (DMSO, 12.0 mL) was formed into a film on the substrate using spin coating. For spin coating, chlorobenzene (0.3 mL) was dropped 30 seconds after the start at 3000 rpm. Thereafter, heating was performed at 150°C for 10 minutes to obtain a perovskite layer (photoelectric conversion layer). Subsequently, ethylenediamine dihydroiodide at 0.5 nm (interface layer), C60 at 20 nm (electron transport layer), bathocuproine (BCP, 8 nm) (electron injection layer), and indium-doped zinc oxide (IZO) at 100 nm were formed into films (second electrode) by vacuum deposition to fabricate a photoelectric conversion element. After fabrication, the solar cell characteristics of the photoelectric conversion element were evaluated.

[Example 8]

A photoelectric conversion element was fabricated in the same manner as Example 7 except that instead of the first transparent film composed of magnesium oxide (MgO) in Example 7, a first transparent film as an optical adjustment film composed of zinc oxide (ZnO) was formed using sputtering such that the film thickness (T1) became 50 nm, and the solar cell characteristics were evaluated. The measurement results of Example 7 and Example 8 are shown in Table 2.

[Table 2]

| Example | First transparent film 2a | | | | Second transparent film 2b | | | | Voc V | Jsc mA/cm$^2$ | FF | PCE % |
|---|---|---|---|---|---|---|---|---|---|---|---|---|
| | Material | Doping concentration (D1) | Refractive index (N1) | Film thickness (T1) | Doping Material concentration (D2) | | Refractive index (N2) | Film thickness (T2) | | | | |
| 7 | MgO | 0% | 1.73 | 20 nm | Indium oxide | 0% | 1.996 | 250 nm | 1.16 | 22.9 | 0.78 | 20.7 |
| 8 | ZnO | " | 1.96 | 50 nm | " | " | " | 250 nm | 1.16 | 22.7 | 0.80 | 21.1 |

The refractive indices of the first transparent film and the second transparent film shown in Table 2 are defined as average refractive indices for light with wavelengths of 300 nm to 1200 nm. The average refractive index N1 of magnesium oxide (MgO), which was the first transparent film, was 1.73, and the average refractive index N1 of zinc oxide (ZnO) was 1.96. The average refractive index N2 of indium oxide ($In_2O_3$) of the second transparent film was 1.996 (approximately 2.0). Since the average refractive index (N1) of the first transparent film and the average refractive index (N2) of the second transparent film had a relationship satisfying N1<N2, reflection due to optical interference occurring at the interface between the films was suppressed, and a laminate of transparent conductive films with high transparency and excellent light transmission characteristics was formed. As a result, the amount of light reaching the photoelectric conversion layer (perovskite layer) through the first transparent film and the second transparent film increased, making it possible to fabricate a photoelectric conversion element having high photoelectric conversion efficiency with PCE (Power Conversion Efficiency) exceeding 20%.

In the case of using the perovskite layer of Example 7 or 8 for the photoelectric conversion layer of the photoelectric conversion element, the average refractive index Np of the perovskite layer was 2.4, and the average refractive index N2 of indium oxide ($In_2O_3$), which was the second transparent film (transparent conductive film), was 1.9 to 2.3. In order to satisfy the relationship of N1<N2, it is preferable to adjust the average refractive index N1 of the optical adjustment film, which is the first transparent film, to be in the range of 1.7 to 2.1, and preferably in the range of 1.8 to 2.0. This makes it possible to enhance the light transmission characteristics of the transparent conductive laminate.

The second transparent film (transparent conductive film) of Example 7 or 8, unlike Examples 1 to 6, carried the current transfer function with a single film of only the second transparent film (transparent conductive film). Therefore, the film thickness T2 of the second transparent film (transparent conductive film) was set to 250 nm. In contrast, the film thickness T1 of the first transparent film (MgO) of Example 7 was formed to 20 nm, and the film thickness T1 of the first transparent film (ZnO) of Example 8 was formed to 50 nm. It is preferable to form the transparent conductive laminate of Example 7 or 8 with the film thickness T1 in the range of 10 nm to 100 nm and the film thickness T2 in the range of 100 nm to 500 nm, and that the respective film thicknesses satisfy the relationship of T1<T2. Furthermore, it is more preferable to satisfy the following formula.

$$70\% \leqq T2/(T1+T2) \leqq 95\%$$

The second transparent film (transparent conductive film) of Examples 7 and 8 was formed as indium oxide ($In_2O_3$) with a doping concentration (D2) of 0% in order to enhance the average transmittance. The second transparent film (transparent conductive film) generally has tin (Sn) or the like added as a doping agent in order to reduce the electrical resistance value, but due to this doping agent, the density of free electrons (carrier concentration) becomes high, the influence of free electrons absorbing visible light appears, and the average transmittance tends to decrease. The second transparent film (transparent conductive film) of this example did not have a doping agent added, but it is considered that the electrical resistance value became low due to crystal defects such as oxygen vacancies generated during sputtering film formation, and reactions with compounds existing at the interface with the first transparent film, perovskite layer, or hole transport layer. Furthermore, the second transparent film (transparent conductive film) was not affected by the doping agent, so the average transmittance became relatively high.

FIG. 7 is a graph showing the relationship between the average transmittance of the transparent conductive laminate used in the photoelectric conversion elements of Examples 7 and 8 and the average refractive index of the optical adjustment film. The average transmittance shown here was the average value of transmittance in the wavelength range of 800 nm to 1100 nm. The average transmittance of a conventional transparent conductive laminate (PET-$In_2O_3$) in which the second transparent film (second transparent conductive film) was formed directly on a PET film (average refractive index 1.63) without the first transparent film (optical adjustment film) therebetween was 0.820. In the case of using silica ($SiO_2$) for the optical adjustment film, the average refractive index was 1.46, resulting in N1>N2 and the average transmittance decreased to 0.80. In contrast, the average transmittance of Example 7 (optical adjustment film: MgO) increased to 0.825, and the average transmittance of Example 8 (optical adjustment film: ZnO) increased to 0.835, and by optimizing the average refractive index of the optical adjustment film to satisfy the relationship of N1<N2, the light transmission characteristics became high. In particular, it is shown that the average transmittance of infrared light became high.

The optical adjustment film that is the first transparent film may be an oxide, nitride, or the like other than magnesium oxide (MgO) or zinc oxide (ZnO) as long as the average refractive index satisfies the relationship of N1<N2. For example, ZnMgO, $SnO_2$, $MoO_3$, and $YMnO_3$ may be used, but not limited thereto. The optical adjustment film functions as an insulating film, but may also have a gas barrier function.

The disclosure has been described above using embodiments and examples. However, the disclosure is not limited to the embodiments and examples described above, and may be arbitrarily and appropriately combined, modified, or selectively adopted as required within the scope that does not depart from the spirit of the disclosure.

Industrial Applicability

As described above, the disclosure provides a photoelectric conversion element with good performance by using a transparent conductive laminate in which the doping concentration (D1) of the transparent conductive film on the side close to the transparent support and the doping concentration (D2) of the transparent conductive film on the side far from the transparent support satisfy D1>D2. The photoelectric conversion element of the disclosure is useful, for example, as a solar cell.

The applications and usage methods of the photoelectric conversion element of the disclosure are not particularly limited, and the photoelectric conversion element of the disclosure is applicable to a wide range of fields with the same applications and usage methods as general photoelectric conversion elements (for example, general solar cells).

Description of Reference Numerals

| | |
|---|---|
| 1 | transparent conductive laminate |
| 2a, 2b | first transparent film and second transparent film (transparent conductive films) |
| 10, 20 | photoelectric conversion element |
| 11, 21 | support |
| 12, 22 | first electrode |
| 13, 23 | electron transport layer |
| 14, 24 | photoelectric conversion layer |
| 15, 25 | hole transport layer |
| 16, 26 | second electrode |

**Claims**

1. A transparent conductive laminate (1), being a laminate comprising transparent conductive films (2a, 2b) that comprise two or more transparent films formed on a light-transmitting support (11), wherein a doping concentration (D1) of a first transparent film (2a) on a side close to the support and a doping concentration (D2) of a second transparent film (2b) on a side far from the support satisfy the following formula,

$$D1>D2...(1).$$

2. The transparent conductive laminate according to claim 1, wherein the first transparent film and the second transparent film have a metal oxide of indium (In) as a main component, and a doping component is tin (Sn) or tungsten (W).

3. A transparent conductive laminate, being a laminate comprising transparent conductive films that comprise two or more transparent films formed on a light-transmitting support, wherein a refractive index (N1) of a first transparent film on a side close to the support and a refractive index (N2) of a second transparent film on a side far from the support satisfy the following formula,

$$N1<N2...(2).$$

4. The transparent conductive laminate according to claim 1 or 3, wherein a film thickness (T1) of the first transparent film and a film thickness (T2) of the second transparent film satisfy the following formula,

$$T1>T2...(3).$$

5. The transparent conductive laminate according to claim 3, wherein the first transparent film is an optical adjustment film having a metal oxide as a main component, and the second transparent film is a transparent conductive film having a metal oxide of indium (In) as a main component.

6. A photoelectric conversion element (10), using a transparent conductive film of the transparent conductive laminate

according to claim 1 or 3 as an electrode for photoelectric conversion element.

7. A photoelectric conversion element (10), comprising the transparent conductive laminate according to claim 1 or 3, a hole transport layer (15), a photoelectric conversion layer (14), an electron transport layer (13), and a second electrode (16) in this order, wherein a first electrode (12) is a transparent conductive film of the laminate, and the hole transport layer is formed on the second transparent film of the transparent conductive film.

8. The photoelectric conversion element according to claim 7, wherein the hole transport layer comprises a compound represented by the following general formula (4),

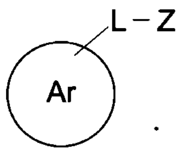

. . . (4)

where in the chemical formula (4), Ar is a structure including an aromatic ring, and may or may not include a hetero atom among atoms constituting the aromatic ring, Ar may or may not have a substituent other than -L-Z, -L-Z may be one or more, and in the case of more than one, each L and each Z may be the same as or different from each other, each L is an atomic group that bonds Ar and Z, or is a covalent bond, and each Z is a group capable of forming a chemical bond or hydrogen bond with a metal oxide.

9. The photoelectric conversion element according to claim 8, wherein the hole transport layer comprises the compound represented by the general formula (4) and a p-type metal oxide.

10. The photoelectric conversion element according to claim 9, wherein the p-type metal oxide is selected from any of nickel oxide, copper oxide, aluminum copper oxide, and aluminum nickel oxide.

11. The photoelectric conversion element according to claim 7, wherein the photoelectric conversion layer is a perovskite layer comprising a perovskite structure.

12. The photoelectric conversion element according to claim 11, comprising insulating nanoparticles between the hole transport layer and the perovskite layer.

13. The photoelectric conversion element according to claim 12, wherein a median particle diameter of the insulating nanoparticles is in a range of 1 nm to 100 nm.

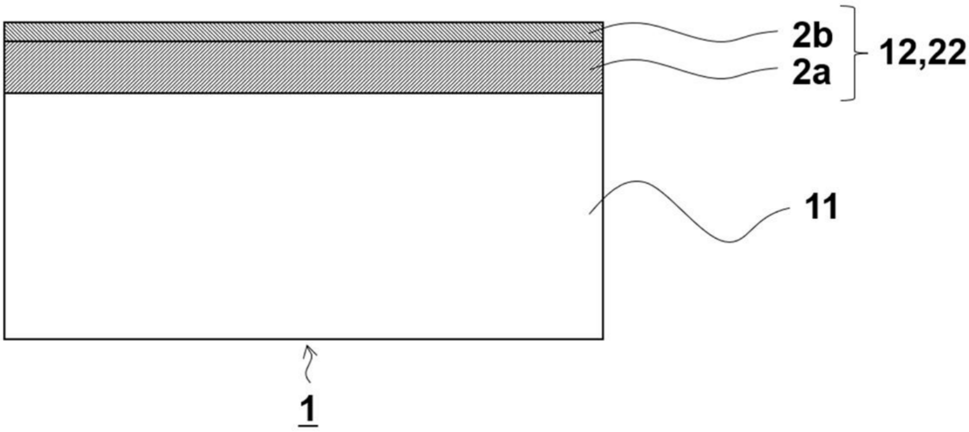


FIG. 1

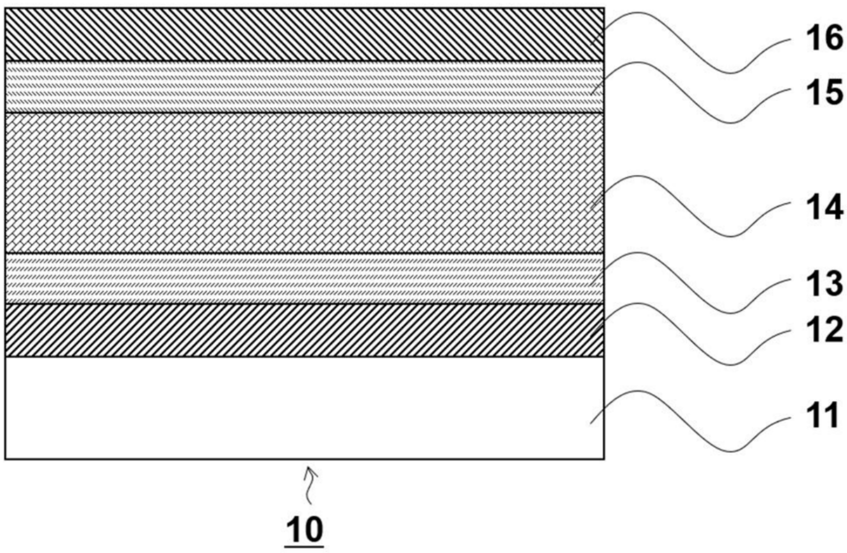


FIG. 2

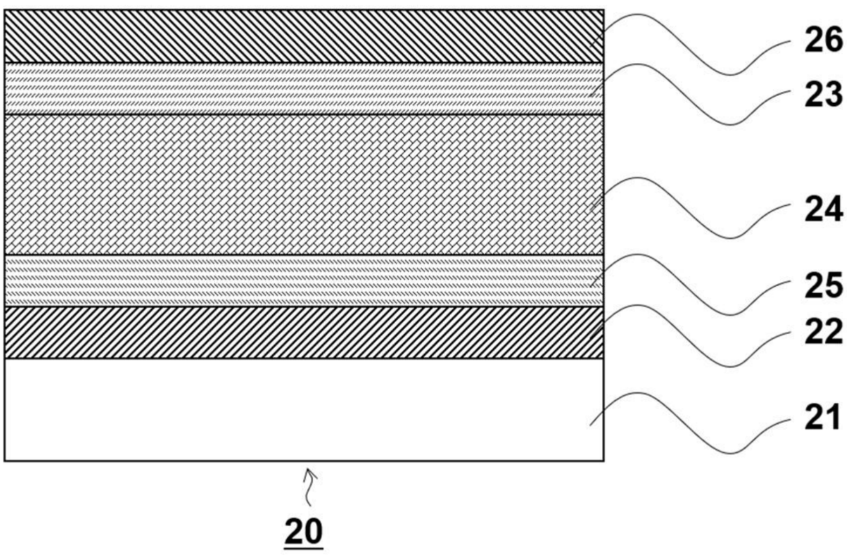


FIG. 3

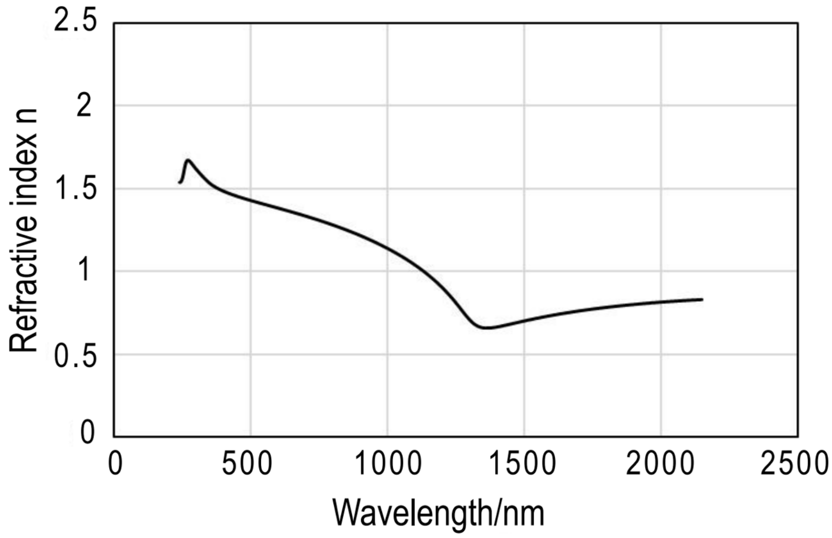


FIG. 4

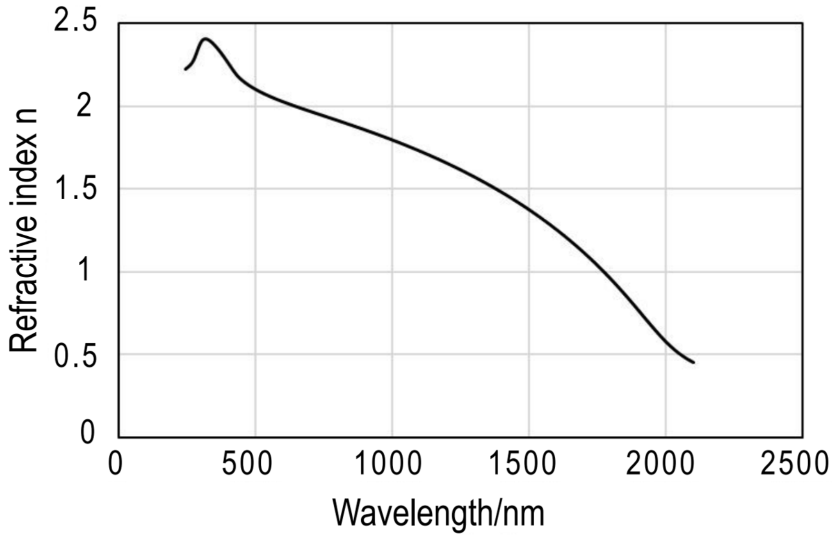


FIG. 5

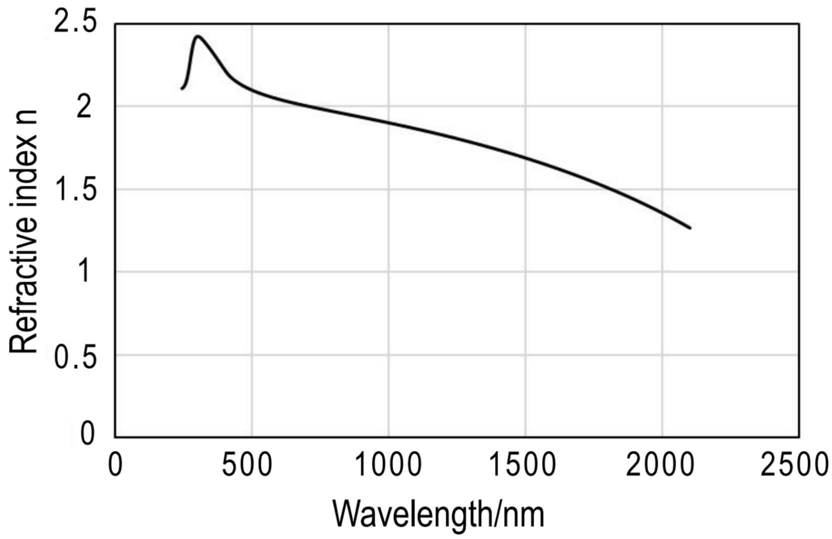


FIG. 6

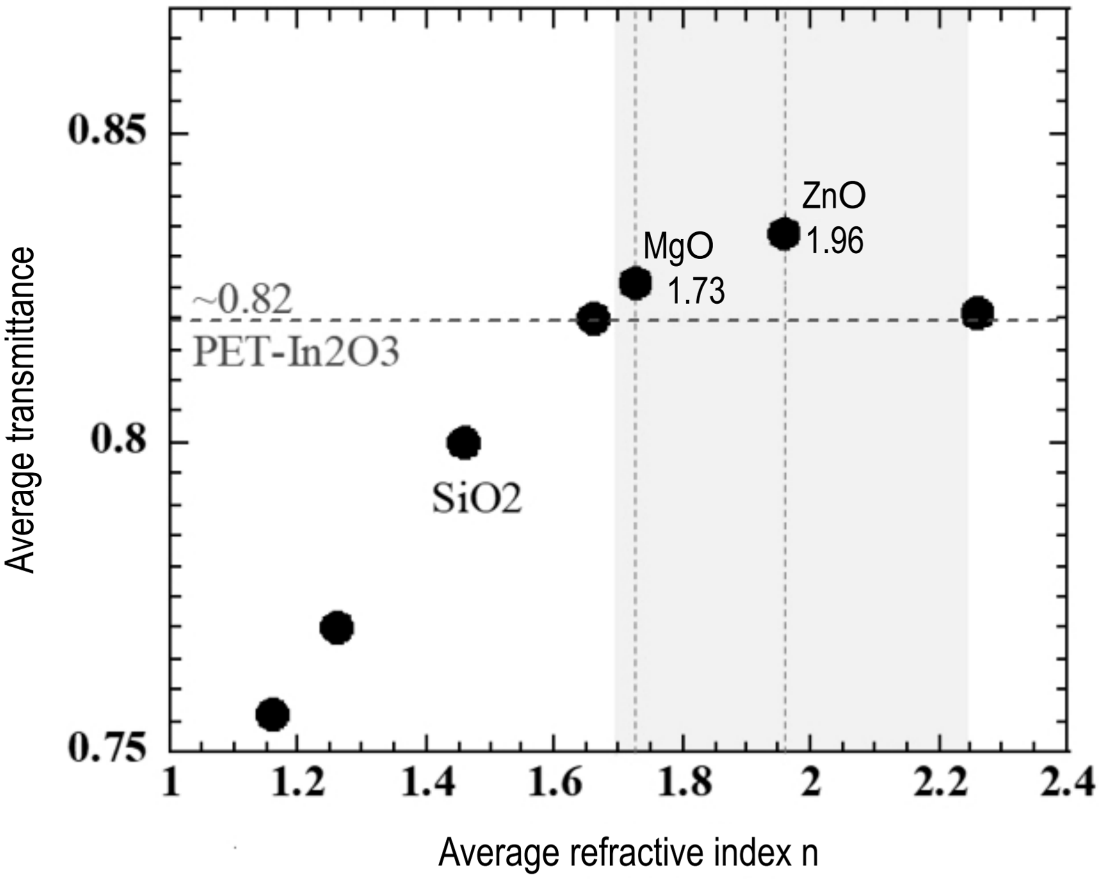
0.85
0.8
0.75
1
1.2
1.4
1.6
1.8
2
2.2
2.4
Average transmittance
Average refractive index n
~0.82
PET-In2O3
SiO2
MgO
1.73
ZnO
1.96

FIG. 7

Europäisches Patentamt
European Patent Office
Office européen des brevets

# EUROPEAN SEARCH REPORT

Application Number
EP 26 15 0556

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 061 041 A1 (MURATA MANUFACTURING CO [JP]) 20 May 2009 (2009-05-20)<br>* paragraphs [0066], [0067], [0071], [0101], [0102]; figure 6; example 1 *<br>----- | 1,6-13 | INV.<br>H10K30/82<br>H10K85/50<br>H10K71/60 |
| X | JP 5 780550 B2 (UNIV TOHOKU [JP]) 16 September 2015 (2015-09-16)<br>* claim 1; figures 21,22 *<br>----- | 1,2,6-13 | |
| X | US 2009/126791 A1 (GUARDIAN INDUSTRIES [US]) 21 May 2009 (2009-05-21)<br>* paragraphs [0026], [0028]; figure 1 *<br>----- | 3-6 | |

TECHNICAL FIELDS SEARCHED (IPC)

H10K

The present search report has been drawn up for all claims

1

| Place of search | Date of completion of the search | Examiner |
|---|---|---|
| The Hague | 8 May 2026 | Fratiloiu, Silvia |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.......................................................................................................
& : member of the same patent family, corresponding document

EPO FORM 1503 03.82 (P04C01)

## ANNEX TO THE EUROPEAN SEARCH REPORT ON EUROPEAN PATENT APPLICATION NO.

EP 26 15 0556

This annex lists the patent family members relating to the patent documents cited in the above-mentioned European search report. The members are as contained in the European Patent Office EDP file on The European Patent Office is in no way liable for these particulars which are merely given for the purpose of information.

08-05-2026

| Patent document cited in search report | Publication date | Patent family member(s) | Publication date |
|---|---|---|---|
| EP 2061041 A1 | 20-05-2009 | CN 101542639 A | 23-09-2009 |
| | | EP 2061041 A1 | 20-05-2009 |
| | | JP 4947051 B2 | 06-06-2012 |
| | | JP WO2008105198 A1 | 03-06-2010 |
| | | KR 20090018598 A | 20-02-2009 |
| | | US 2008280119 A1 | 13-11-2008 |
| | | WO 2008105198 A1 | 04-09-2008 |
| JP 5780550 B2 | 16-09-2015 | JP 5780550 B2 | 16-09-2015 |
| | | JP WO2011093274 A1 | 06-06-2013 |
| | | TW 201212047 A | 16-03-2012 |
| | | WO 2011093274 A1 | 04-08-2011 |
| US 2009126791 A1 | 21-05-2009 | US 2009126791 A1 | 21-05-2009 |
| | | US 2011094580 A1 | 28-04-2011 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- *Journal of the American Chemical Society*, 2009, vol. 131, 6050-6051
- *Science*, 2012, vol. 388, 643-647